# EUROPEAN PATENT SPECIFICATION

(11) **EP 2 852 980 B1**
(45) Date of publication and mention of the grant of the patent: **07.04.2021**
(21) Application number: 13794029.2
(22) Date of filing: 09.05.2013
(51) Int. Cl.: H01L 29/778, H01L 21/336, H01L 29/06, H01L 21/308, H01L 21/027, H01L 29/423, H01L 29/20

(54) **HEMT DEVICE AND METHOD OF MANUFACTURING THE SAME**
HEMT-VORRICHTUNG UND VERFAHREN ZUR HERSTELLUNG DAVON
DISPOSITIF TRANSISTOR À HAUTE MOBILITÉ D'ÉLECTRONS ET SON PROCÉDÉ DE FABRICATION

(30) Priority: 23.05.2012 US 201213479018; 23.05.2012 US 201213478402; 23.05.2012 US 201213478609
(43) Date of publication of application: 01.04.2015
(73) Proprietor: HRL Laboratories, LLC, Malibu, CA 90265-4799 (US)
(72) Inventor: KHALIL, Sameh, Calabasas, California 91302 (US); BOUTROS, Karim S., Moorpark, California 93021 (US)
(74) Representative: Gulde & Partner
(86) International application number: PCT/US2013/040447
(87) International publication number: WO 2013/176906

(56) References cited:
- KR-A- 20110 026 798
- US-A1- 2009 315 075
- US-A1- 2010 055 882
- US-A1- 2010 140 663
- US-A1- 2011 049 526
- US-A1- 2011 057 257
- US-A1- 2011 127 541
- US-B1- 8 124 505
- US-B2- 6 884 732
- WUERFL J ET AL: "Reliability issues of GaN based high voltage power devices", MICROELECTRONICS AND RELIABILITY, ELSEVIER SCIENCE LTD, GB, vol. 51, no. 9, 5 July 2011 (2011-07-05), pages 1710-1716, XP028291317, ISSN: 0026-2714, DOI: 10.1016/J.MICROREL.2011.07.017 [retrieved on 2011-07-21]

## Description

### Technical Field

This invention relates to III-Nitride HEMT devices having a non-uniform Two-Dimensional Electron Gas (2DEG) profile in the carrier supplying layer thereof.

### Background

III-Nitride High Electron Mobility Transistor (HEMT) devices are often used in power applications and/or high temperature applications in RF circuits and in other applications, including in power supplies for electrically powered motor vehicles.

A design trade-off between the on-state resistance (Rₒₙ) and breakdown voltage (BV) of a HEMT can be improved significantly by following the teachings contained herein. Since the relation between the BV and Rₒₙ is at least quadratic, improvement in the BV for a given drift region length results in a significant improvement in the figure of merit (FOM) of the device, defined as BV²/Rₒₙ.

HEMTs utilize two semiconductor materials with different band-gaps, forming an electron potential well at a heterointerface between the two semiconductor materials, which materials might be, for example, AlGaN and GaN. The potential well confines electrons and defines a two-dimensional electron gas (2DEG) conduction channel. Due to the two-dimensional nature of the electrons in the conduction channel, the carrier mobility is enhanced.

Prior art III-Nitride HEMTs utilize a uniform 2DEG density which results in a peak electric field under or near the gate region. The electric field distribution tends to be closer to a triangular shape than to a more desirable trapezoidal shape which reduces the BV per unit drift region length of the device. The use of a field plate and/or multi step field plates are some of the techniques that are used in the prior art to improve the electric field distribution but these techniques typically result in multiple peaks and suffer from less than ideal flat field distribution (they can exhibit a saw tooth type profile) which also adds to the gate to drain capacitance. In addition, process complexity and cost typically increase with the number of field plate steps (levels) utilized.

The prior art includes:
Park et al., U.S. Patent Appl. No.: US 2011/0057257 published on March 10, 2011 discloses a semiconductor device comprising a semiconductor layer, wherein the semiconductor layer having an upper layer whose thickness is increased toward a first direction facing the drain electrode from the gate structure. Sato, U.S. Patent Appl. No.: US 2009/0315075 published on December 24, 2009 discloses a semiconductor device comprising a nitride group semiconductor region which has different thicknesses between the second main electrode and the gate electrode, and between the first main electrode and the gate electrode. Imhoff et al., U.S. Patent Appl. No.: US 2010/0055882 published on March 4, 2010 discloses methods for producing a junction termination extension surrounding the edge of a cathode or anode junction in a semiconductor substrate.
Furukawa, U.S. Patent No.: US 7,038,253 issued on May 2, 2006 discloses a GaN based device that represents state of the art GaN on Si technology which uses a uniform 2DEG profile in the drift region. In the absence of any field shaping technique it is expected that the breakdown and dynamic Rdson performance of the device of this patent will be limited by a localized increase in the electric field under the gate region thus requiring over design of the device which degrades the Figure of Merit (FOM) that can be achieved by such a structure.
H. Xing et al. have proposed a device structure that was published in a paper entitled "High Breakdown Voltage AlGaN/GaN HEMTs achieved by Multiple Field Plates" (see H. Xing, Y. Dora, A. Chini, S. Hikman, S. Keller and U.K. Mishra, "High Breakdown Voltage AlGaN-GaN HEMTs Achieved by Multiple Field Plates," IEEE Electron Device Letters, IEEE ELECTRON DEVICE LETTERS, VOL. 25, NO. 4, pp. 161-163, April 2004), which utilizes a field shaping technique that used multiple field plates to improve the electric field distribution, however, this technique is less favorable than the technology disclosed herein since multiple field plates will not achieve a uniform electric field (will have a saw tooth type distribution) and will increase the gate to drain capacitance. In implementing such structure increases device complexity and cost.
C. M. Waits, R. Ghodssi, and M. Dubey, "Gray-Scale Lithography for MEMS Applications", University of Maryland,Department of Electrical and Computer Engineering, Institute for Advanced Computer Studies, College Park, Maryland, USA, 2006.
W. Henke, W. Hoppe, H. J. Quenzer, P.Staudt- Fischbach and B. Wagner, "Simulation and experimental study of gray-tone lithography for the fabrication of arbitrarily shaped surfaces," Proc. IEEE Micro Electro Mechanical Syst. MEMS 1994, Oiso, Japan, pp. 205-210.
C. M. Waits, R. Ghodssi, M. H. Ervin, M. Dubey, "MEMS-based Gray-Scale Lithography," International Semiconductor Device Research Symposium (ISDRS), December 5-7, 2001, Washington D.C.

### Brief description of the Invention

The invention is concerned with a HEMT device according to claim 1 and a method of making a HEMT device according to claim 5, implementing a non-uniform two dimensional electron gas profile between the gate and drain electrodes. By implementing a tapered AlGaN layer (charge supplying layer) from the gate to the drain, one can obtain a monotonically increasing 2DEG profile that results in a uniform electric field distribution hence maximizing the FOM of the device.

### Brief Description of the Drawings

Fig. 1a is a schematic presentation of charge density before tapering the carrier supplying layer (preferably AlGaN), hence the uniform 2DEG density (depth is not drawn to scale) of a partially formed HEMT device;
Fig. 1b is a schematic presentation of charge density after tapering the carrier supplying layer (preferably AlGaN) hence the non-uniform 2DEG density (depth is not drawn to scale) of the partially formed HEMT device of Fig. 1a after the AlGaN layer has been tapered;
Fig. 1c is similar to Fig. 1b, but depicts the partially formed HEMT device of Fig. 1b in a perspective view as opposed to an elevational view thereof;
Fig. 2 is a schematic presentation of charge density (depth is not drawn to scale) of the preferred embodiment of a completed HEMT device of Fig. 1a after the carrier supplying layer (preferably AlGaN) has been tapered in the region between the gate and the drain;
Fig. 3 depicts an alternative, unclaimed method of creating a taper in the carrier supplying layer (preferably AlGaN);
Fig. 4 depicts both the electric field distribution (which is flat) and the tapered 2DEG density for the device of Fig. 2; and
Fig. 5 depicts both the electric field distribution (which is tapered) and a flat 2DEG density for prior art HEMT devices having zero, one and two field plates.

### Detailed Description

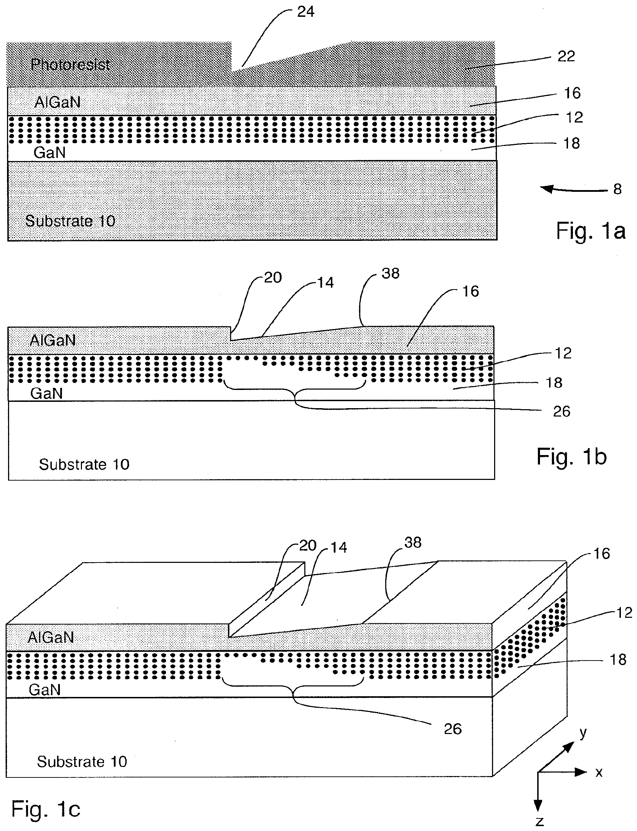

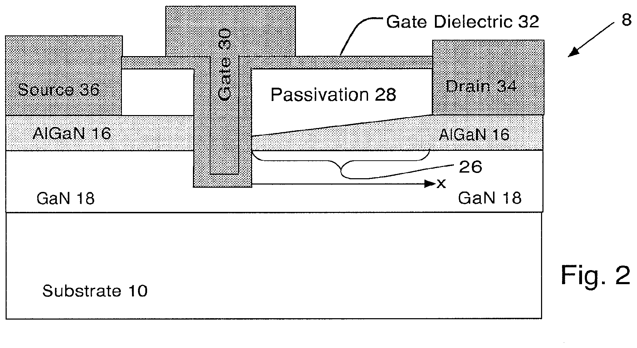

As depicted by Figs. 1a, 1b, 1c and 2, and in order to improve the electric field distribution along the drift region 26 (the region between the gate 30 and the drain 34) and hence improve the breakdown voltage capability per unit drift region length of a HEMT device 8, a non-uniform lateral 2DEG profile 12 along the drift region in layer 18 is provided, in one preferred embodiment, by monotonically tapering the profile (thickness or z-direction) of a carrier supplying layer 16 alone the x-direction between the gate 30 and drain 34. The taper is identified by numeral 14 in Figs. 1b and 1c. The carrier supplying layer 16 may be, for example, AlGaN in an AlGaN/GaN HEMT. Monotonically tapering the profile (thickness) of the carrier supplying layer 16 effectively creates a non-uniform profile of two dimensional electron gas (2DEG) 12 where the 2_DEG density increases with the increasing thickness of carrier supplying layer 16.

Fig. 1a shows HEMT device 8 in the process of being fabricated. The gate, source and drain electrodes of the device 8 have not yet been formed. The device 8 in the process of being fabricated is comprised in this figure of a stack of III-V layers, preferably grown on a substrate 10. Substrate 10 may be any of the suitable substrates that are commonly used to grow III-Nitride materials, for example Si, Sapphire, SiC, bulk single crystal GaN, and others. As can be seen in Fig. 1a, substrate 10 provides a supporting surface for a layer 18 of GaN material in one embodiment (but other materials such as AlGaN may be used instead for layer 18) or a superlattice formed of alternating layers (e.g. alternating AlGaN/GaN or alternating AIN/GaN) may be used instead for layer 18 or a combination of C-doped GaN buffer and AlGaN back barrier may be used instead for layer 18 or any combination of the aforementioned in still other embodiments may prove to be suitable for layer 18, which layer functions as a buffer layer in HEMT device 8.

A carrier supplying layer 16 is preferably formed of AlGaN material and preferably with a suitable Al mole fraction that typically ranges between 20 to 30%, and is grown or otherwise formed on buffer layer 18. Fig. 1a also shows a layer of photoresist 22 disposed on the carrier supplying layer 16, which layer 22 has been photolithographically processed, preferably by gray scale lithography, to allow a triangularly shaped wedge (when viewed in cross section) portion 24 to be etched away from the photoresist layer 22. The layer of photoresist 22 and its triangularly shaped wedge portion 24 is then removed during a subsequent RIE etch process which transfers the wedge pattern 24 from the photoresist 22 and into the carrier supplying layer 16 to thereby define taper 14 therein (see Figs. 1b and/or 1c). The process is preferably optimized so that photoresist 22 remains in the area where the carrier supplying layer 16 layer is preferably kept intact outside the taper area 14 so that its thickness is preferably not decreased outside of the taper or wedge region 14 by the aforementioned RIE etch. Any remaining photoresist 22 may thereafter be removed removed with a suitable chemical etchant.

The thicker the carrier supplying layer 16 in a given position in the x-direction along the drift region 26 (see Fig. 2) where x is the horizontal direction from the edge of gate 30 (facing the drain, where x=0) towards the drain 34 (where x=LD at the edge of drain 34 facing the gate 30). The taper 14 in carrier supplying layer 16 (see Figs. 1b and/or 1c) is preferably produced by gray scale photolithography of the photoresist layer 22 (to remove the photoresist wedge portion 24 therefrom) as mentioned above. This process is followed by the aforementioned controlled RIE where initially the remaining photoresist 22 is removed in the area of the wedge pattern 24 and eventually is completely removed either as the RIE process progresses or by the chemical etch mentioned above. The carrier supplying layer 16 under the thinner part of the wedge pattern 24 experiences a longer RIE etch time than carrier supplying layer 16 under a thicker part of the wedge pattern 24, resulting in a profile transfer from the photoresist wedge pattern 24 to the carrier supplying layer 16. The carrier supplying layer's thickness is preferably uniform in a lateral direction along the lateral extents of the gate or drain regions (along the y-direction of Fig. 1c).

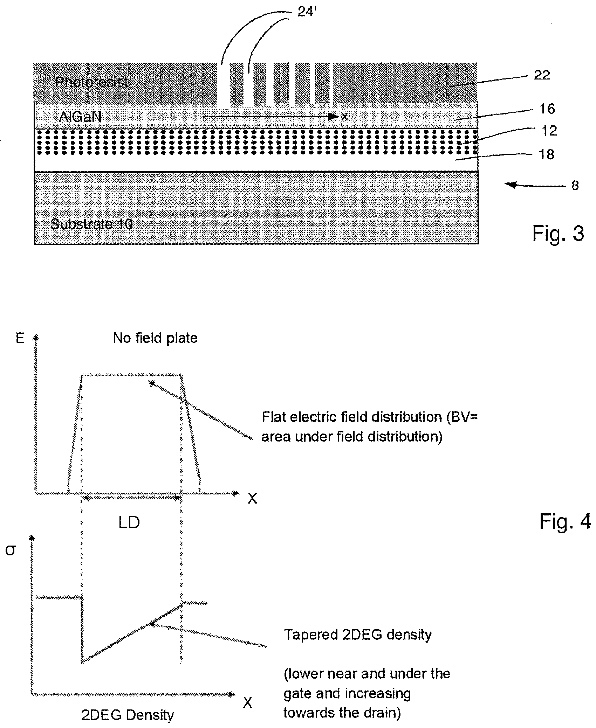

An alternative, unclaimed method for forming such a tapered pattern or wedge 14 in the carrier supplying layer 16 is shown in Fig. 3. This alternative method involves opening windows or vias 24' in the photoresist layer 22 with varying sizes where the size of the opening is a function of the lateral distance from where the gate will be formed to where the drain will be formed (the pattern is similar to that typically used in Gray scale lithography). Since the photoresist 22 is completely removed in the open windows or vias 24', the loading effect of the RIE etch will result in a faster etch rate in larger photoresist window openings than in smaller window openings hence implementing a taper 14 in the carrier supplying layer 16 as depicted by Figs. 1b and 1c. The mask pattern in this alternative method is similar to a conventional gray scale mask, but rather than relying on the intensity of light for making different openings to create a tapered profile 24 in the photoresist 22, this alternative method relies on the loading effect of the RIE etch process to etch more of the carrier supplying layer 16 in the wider open windows.

Irrespective of which method is used to form the taper 14, the taper 14 ends at a step 20 (see Fig. 1b or 1c) back to the normal height of layer 16 near where the gate 30 will be formed. The taper 14 smoothly ends where the carrier supplying layer 16 returns to its otherwise normal height at the other end 38 of the wedge or taper 14 near (and preferably immediately adjacent) where the drain 34 will be formed. The gate 30, drain 34 and a passivation layer 28 with eventually occupy this region as shown in Fig. 2. Fig. 1b illustrates that the taper 14 varies in the x-direction. Fig. 1c illustrates that the taper 14 preferably does not vary in the y-direction.

After the tapering of the AlGaN layer 16 is completed preferably using the techniques discussed above with respect to either Fig. 1a and 1b or Fig. 3, ohmic contacts 36 and 34 to the source and drain 2DEG regions are formed preferably using a stack of metal lift off followed by an Rapid Thermal Anneal (RTA) treatment. Thereafter a dielectric 28 is deposited at the exposed surfaces for passivation and it is subsequently patterned in the source and drain contact 36 and 34 areas to open the ohmic contacts 36 and 34 followed by the formation of a gate 30 stack. First a gate foot is preferably etched in the passivation dielectric 28 using either a dry etching or wet etching or a combination of dry/wet etching. The techniques disclosed herein are suitable for use with either an enhancement mode HEMT device or a depletion mode HEMT device. In a preferred embodiment, as in an enhancement mode device, a fluorine treatment or a combination of fluorine treatment and gate recess (with a further dry etch) can be performed to deplete the channel under the gate 30 of its 2DEG. Thereafter a suitable gate dielectric 32 is deposited. In a preferred embodiment the gate dielectric 32 could by of Al₂O₃ oxide deposited by atomic layer deposition, however, gate dielectric materials other than Al₂O₃ may be utilized.

A gate 30 metal stack is then deposited and patterned. Further steps to implement multi-step field plates can then be used where the cumulative effects of field shaping techniques using both non-uniform 2DEG density profile and multi-step field plate techniques can be combined. Additional inter-metallic dielectric and metal layers may be used to reduce the interconnect resistance particularly if the resulting HEMT is a large power device.

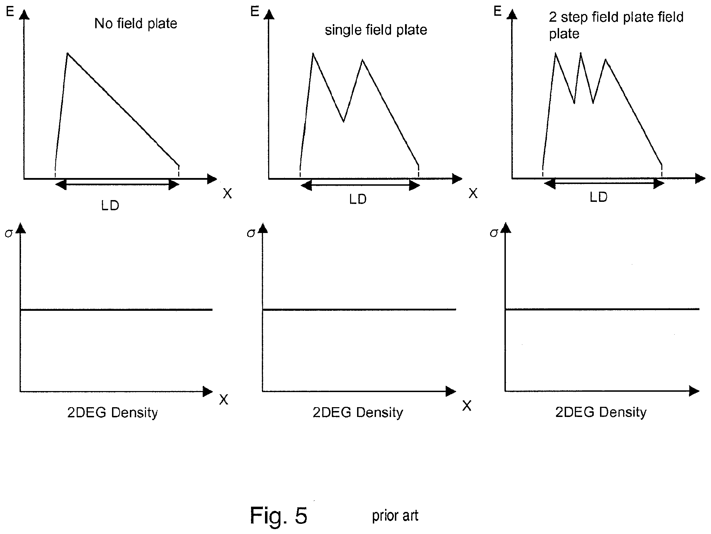

Since the density of charge in the 2DEG region 12 is determined locally by the thickness of the carrier supplying layer 16 at any given position, a non uniform 2DEG distribution is achieved by controlling the height (thickness) of the carrier supplying layer 16 which should increase as a function of distance laterally away from the gate 30 along the drift region toward the drain 34. See Fig. 2 where the right hand side of the gate 30 structure is preferably positioned where the step 20 formerly occurred and the left hand side of the drain 34 is preferably positioned at the other end 38 of the wedge or taper 14. The dependence of the 2DEG density on the thickness of the carrier supplying layer 16 is illustrated in the following paper: Smorchkova, I. P. et al., "Polarization-induced charge and electron mobility in AlGaN/GaN heterostructures grown by plasma-assisted molecular epitaxy," Journal of Applied Physics, Volume 86, Issue 8, pp. 4520-4526, Oct. 1999, and in particular Fig. 5c.

From the band energy diagram of Fig. 5, which is from the paper by Smorchkova, I. P. et al identified above, it can be seen that when a thin AlGaN layer is utilized as the carrier supplying layer 16, the Fermi level is above the donor surface states level which results in the donors atoms being filled and not supplying the 2DEG electrons to the well at the GaN/AlGaN interface. As the AlGaN thickness increases the Fermi level moves downwards and eventually overlaps with the donor state energy level resulting in some of the donors are being empty with their originally compensating electrons being transferred to the 2DEG well. The further the overlap is the higher the 2DEG density is.

A flat electric field distribution is achieved using the non-uniform 2DEG density concept as shown in Fig. 5 of the paper by Smorchkova, I. P. et al identified above which maximizes the lateral breakdown voltage per unit length of the drift region and improves immunity to dynamic Rₒₙ degradation. In contrast, as shown in Figs. 5a-5c for various configurations, if a uniform 2DEG density profile is used, then the electric field profile is either triangular (no field plate) or has multiple peaks as shown in Figs. 5b and 5c (multiple field plates). The uniform 2DEG and zero or more field plates results in a reduced breakdown voltage BV and less immunity to dynamic Rₒₙ degradation compared tapered 2DEG distribution shown in Fig. 4.

If one adds one or more field plates to the embodiment of Fig. 2 as mentioned above, that will increase the complexity of the process since additional process steps are then required which will increase the cost of making the device. However, adding one or more field plates to the embodiment of Fig. 2 may yield additional performance benefits. Whether the improvement in performance by adding one or more field plates to the embodiment of Fig. 2 is justified by the increase in cost of manufacture is a matter of design choice.

Not shown in the drawings, but as is well known, a spacer layer of AIN, for example, may be inserted between layers 16 and 18 to improve device electrical performance.

This concludes the detailed description including preferred embodiments of the present invention. The foregoing description including preferred embodiments of the invention has been presented for the purposes of illustration and description. It is not intended to be exhaustive or to limit the invention to the precise forms disclosed. Many modifications and variations are possible within the scope of the foregoing teachings. Additional variations of the present invention may be devised without departing from the inventive concepts as set forth in the following claims.

## Claims

1. A HEMT device (8) comprising:
a. a substrate (10);
b. a buffer layer (18) disposed above said substrate (10);
c. a carrier supplying layer (16) disposed above said buffer layer (18);
d. a gate (30) element penetrating said carrier supplying layer (16); and
e. a drain (34) element disposed on said carrier supplying layer (16),
wherein the carrier supplying layer (16) has a thickness increasing along a monotonic taper (14) formed from said gate (30) element to said drain (34) element,
**characterised in that**
said monotonic taper is formed as bottom of a recess in the carrier supplying layer (16), the recess being triangularly shaped when viewed in cross-section.

2. The HEMT device (8) of claim 1, wherein the buffer layer (18) contains GaN and wherein the carrier supplying layer (16) contains AlGaN.

3. The HEMT device (8) of claim 1 or 2, wherein the buffer layer (18) and the carrier supplying layer (16) comprise different group III-Nitride compounds.

4. The HEMT device (8) of one of the preceding claims, wherein a two-dimensional electron gas (12) conduction channel is formed in said buffer layer (18), the two-dimensional electron gas (12) conduction channel having a non-uniform profile between said gate (30) and drain (34) elements.

5. A method of making a HEMT device (8) comprising:
a. forming a substrate (10);
b. disposing a buffer layer (18) above said substrate (10);
c. disposing a carrier supplying layer (16) above said buffer layer (18);
d. forming a layer of a photoresist (22) on said carrier supplying layer (16);
e. etching away a triangularly shaped wedge portion (24), when viewed in cross-section, of said layer of a photoresist (22) using gray scale lithography so as to create a wedge pattern in said layer of a photoresist (22);
f. removing said layer of a photoresist (22) using a RIE etch process to transfer the wedge pattern from the layer of a photoresist (22) into the carrier supplying layer (16) to thereby etch a recess in the carrier supplying layer (16), the recess having as bottom a monotonic taper (14) from a starting point to an ending point; and
g. forming a gate (30) element at said starting point and forming a drain (34) element at said ending point, the gate (30) element penetrating the carrier supplying layer (16), the carrier supplying layer (16) increasing in thickness along said monotonic taper from said gate element to said drain element.

6. The method of claim 5, further including filling at least the region of the carrier supplying layer (16) etched via the triangularly shaped wedge portion (24) with passivation (28) material.

7. The method of claim 5 or 6, wherein the step of forming the gate (30) element includes forming a gate dielectric layer and a metallic gate.

## Patentansprüche

1. Eine HEMT-Vorrichtung (8), aufweisend:
a. ein Substrat (10);
b. eine Pufferschicht (18), die über dem besagten Substrat (10) angeordnet ist;
c. eine Trägerversorgungsschicht (16), die über der besagten Pufferschicht (18) angeordnet ist;
d. ein Gate (30)-Element, das die besagte Trägerversorgungsschicht (16) durchdringt; und
e. ein Drain (34)-Element, das auf der besagten Trägerversorgungsschicht (16) angeordnet ist,
wobei die Trägerversorgungsschicht (16) eine Dicke aufweist, die entlang einer monotonen Verjüngung (14), die vom besagten Gate (30)-Element zum besagten Drain (34)-Element ausgebildet ist, zunimmt,
**dadurch gekennzeichnet, dass**
die besagte monotone Verjüngung als Unterseite einer Ausnehmung in der Trägerversorgungsschicht (16) ausgebildet ist, wobei die Ausnehmung, im Querschnitt betrachtet, dreieckig geformt ist.

2. Die HEMT-Vorrichtung (8) nach Anspruch 1, wobei die Pufferschicht (18) GaN enthält und wobei die Trägerversorgungsschicht (16) AlGaN enthält.

3. Die HEMT-Vorrichtung (8) nach Anspruch 1 oder 2, wobei die Pufferschicht (18) und die Trägerversorgungsschicht (16) unterschiedliche Gruppe-III-Nitrid-Verbindungen aufweisen.

4. Die HEMT-Vorrichtung (8) nach einem der vorhergehenden Ansprüche, wobei ein zweidimensionaler Elektronengas (12)-Leitungskanal in der besagten Pufferschicht (18) ausgebildet ist, wobei der zweidimensionale Elektronengas (12)-Leitungskanal ein nicht gleichmäßiges Profil zwischen dem besagten Gate (30)-Element und dem besagten Drain (34)-Element aufweist.

5. Ein Verfahren zur Herstellung einer HEMT-Vorrichtung (8), aufweisend:
a. Ausbilden eines Substrats (10);
b. Anordnen einer Pufferschicht (18) über dem besagten Substrat (10);
c. Anordnen einer Trägerversorgungsschicht (16) über der besagten Pufferschicht (18);
d. Ausbilden einer Schicht aus einem Fotolack (22) auf der besagten Trägerversorgungsschicht (16);
e. Wegätzen eines, im Querschnitt betrachtet, dreieckig geformten Keilabschnitts (24) der besagten Schicht aus einem Fotolack (22) mittels einer Graustufen-Lithografie, um ein Keilmuster in der besagten Schicht aus einem Fotolack (22) zu erzeugen;
f. Entfernen der besagten Schicht aus einem Fotolack (22) mittels eines RIE-Ätzverfahrens, um das Keilmuster von der Schicht aus einem Fotolack (22) in die Trägerversorgungsschicht (16) zu übertragen, um dadurch eine Ausnehmung in der Trägerversorgungsschicht (16) zu ätzen, wobei die Ausnehmung als Unterseite eine monotone Verjüngung (14) von einem Anfangspunkt bis zu einem Endpunkt aufweist; und
g. Ausbilden eines Gate (30)-Elements am besagten Anfangspunkt und Ausbilden eines Drain (34)-Elements am besagten Endpunkt, wobei das Gate (30)-Element die Trägerversorgungsschicht (16) durchdringt, wobei die Trägerversorgungsschicht (16) hinsichtlich der Dicke entlang der monotonen Verjüngung vom besagten Gate-Element zum besagten Drain-Element zunimmt.

6. Das Verfahren nach Anspruch 5, ferner aufweisend Füllen zumindest des Bereichs der Trägerversorgungsschicht (16), der durch den dreieckig geformten Keilabschnitt (24) weggeätzt ist, mit Passivierungs (28)-Material.

7. Das Verfahren nach Anspruch 5 oder 6, wobei der Schritt des Ausbildens des Gate (30)-Elements Ausbilden einer dielektrischen Gate-Schicht und eines Metall-Gate aufweist.

## Revendications

1. Un dispositif transistor à haute mobilité d'électrons (8), comprenant :
a. un substrat (10) ;
b. une couche tampon (18) disposée au-dessus dudit substrat (10) ;
c. une couche d'alimentation en porteur de charge (16) disposée au-dessus de ladite couche tampon (18) ;
d. un élément de grille (30) pénétrant ladite couche d'alimentation en porteur de charge (16) ; et
e. un élément de drain (34) disposé sur ladite couche d'alimentation en porteur de charge (16),
la couche d'alimentation en porteur de charge (16) ayant une épaisseur augmentant le long d'un cône monotone (14) formé depuis ledit élément de grille (30) jusqu'audit élément de drain (34),
**caractérisé en ce que**
ledit cône monotone est formé en tant que face inférieure d'un évidement dans la couche d'alimentation en porteur de charge (16), l'évidement étant de forme triangulaire lorsqu'il est vu en coupe transversale.

2. Le dispositif transistor à haute mobilité d'électrons (8) selon la revendication 1, dans lequel la couche tampon (18) contient du GaN et dans lequel la couche d'alimentation en porteur de charge (16) contient de l'AlGaN.

3. Le dispositif transistor à haute mobilité d'électrons (8) selon la revendication 1 ou 2, dans lequel la couche tampon (18) et la couche d'alimentation en porteur de charge (16) comprennent différents composés de nitrure du groupe III.

4. Le dispositif transistor à haute mobilité d'électrons (8) selon l'une des revendications précédentes, dans lequel un canal de conduction de gaz d'électrons (12) bidimensionnel est formé dans ladite couche tampon (19), le canal de conduction de gaz d'électrons (12) bidimensionnel ayant un profil non uniforme entre lesdits éléments de grille (30) et de drain (34).

5. Un procédé de fabrication d'un dispositif transistor à haute mobilité d'électrons (8), comprenant :
a. former un substrat (10) ;
b. disposer une couche tampon (18) au-dessus dudit substrat (10) ;
c. disposer une couche d'alimentation en porteur de charge (16) au-dessus de ladite couche tampon (18) ;
d. former une couche de photorésine (22) sur ladite couche d'alimentation en porteur de charge (16) ;
e. enlever par gravure une partie de coin (24) de forme triangulaire, telle que vue en coupe transversale, de ladite couche de photorésine (22) par lithographie en échelle de gris de manière à produire un motif en coin dans ladite couche de photorésine (22) ;
f. enlever ladite couche de photorésine (22) par un procédé de gravure RIE pour transférer le motif en coin de la couche de photorésine (22) dans la couche d'alimentation en porteur de charge (16) pour graver ainsi un évidement dans la couche d'alimentation en porteur de charge (16), l'évidement ayant comme face inférieure un cône monotone (14) allant d'un point de départ à un point d'arrivée ; et
g. former un élément de grille (30) au niveau dudit point de départ et former un élément de drain (34) au niveau dudit point d'arrivée, l'élément de grille (30) pénétrant la couche d'alimentation en porteur de charge (16), la couche d'alimentation en porteur de charge (16) augmentant en épaisseur le long dudit cône monotone depuis ledit élément de grille jusqu'audit élément de drain.

6. Le procédé selon la revendication 5, comprenant en outre le remplissage d'au moins la région de la couche d'alimentation en porteur de charge (16) gravée par la partie de coin de forme triangulaire (24) d'un matériau de passivation (28).

7. Le procédé selon la revendication 5 ou 6, dans lequel l'étape de formation de l'élément de grille (30) comprend la formation d'une couche diélectrique de grille et d'une grille métallique.
